# EUROPEAN PATENT APPLICATION

(11) **EP 4 120 322 A1**
(43) Date of publication of application: **18.01.2023**
(21) Application number: 21767897.8
(22) Date of filing: 04.03.2021
(51) Int. Cl.: H01L 21/304

(54) **POLISHING COMPOSITION AND POLISHING METHOD**

(30) Priority: 13.03.2020 JP 2020044715
(71) Applicant: Fujimi Incorporated, Kiyosu-shi, Aichi 452-8502 (JP)
(72) Inventor: TSUCHIYA, Kohsuke, Kiyosu-shi, Aichi 452-8502 (JP)
(74) Representative: Grünecker Patent- und Rechtsanwälte PartG mbB
(86) International application number: PCT/JP2021/008369
(87) International publication number: WO 2021/182278

(57) **Abstract**

Provided is a polishing composition that can achieve haze reduction and wettability enhancement of a polished surface of a silicon wafer. This polishing composition contains silica particles, a cellulose derivative, a basic compound, and water. Here, the silica particles have an average primary particle diameter of 30 nm or less and an average secondary particle diameter of 60 nm or less. The cellulose derivative has a weight average molecular weight of more than 120 × 10⁴.

## Description

### [Technical Field]

The present invention relates to a polishing composition for a silicon wafer. The present invention also relates to a polishing method for a silicon wafer using the polishing composition. The present application claims priority based on Japanese Patent Application No. 2020-044715 filed on March 13, 2020, the entire contents of which application are incorporated herein by reference.

### [Background Art]

The surface of a silicon wafer used as a component of a semiconductor device or the like is generally finished into a high-quality mirror surface through a lapping step (rough polishing step) and a polishing step (fine polishing step). The polishing step typically includes a stock polishing step (preliminary polishing step) and a final polishing step (finish polishing step). For example, Patent Literature 1 is cited as technical literature on polishing compositions for silicon wafers.

### [Citation List]

### [Patent Literature]

[Patent Literature 1] Japanese Patent No. 5196819

### [Summary of Invention]

### [Technical Problem]

A silicon wafer is required to have a high-quality surface. Therefore, in addition to an abrasive and water, a polishing composition for such applications suitably contains a water-soluble polymer for the purpose of protecting the surface of an object to be polished, improving the wettability, and the like. By keeping the polished surface wetted with water (keeping a water layer adhering thereto), the direct adhesion of contaminants or the like in the air on the polished surface of the silicon wafer can be prevented and the surface defects due to the contaminants and the like can be reduced. The surface with such wettability tends to have suitable cleanability and can easily have higher quality by the cleaning. For example, Patent Literature 1 suggests a polishing composition containing hydroxyethyl cellulose as a water-soluble polymer in addition to silica particles as an abrasive.

In order to achieve the high-quality surface, it is important to reduce haze. In view of this, it is more preferable to achieve the lower haze while improving the wettability of the polished surface of the silicon wafer as described above. However, the conventional compositions containing cellulose derivatives as described in Patent Literature 1 do not necessarily exhibit sufficient wettability and there is room for improvement about the haze.

In view of this, it is an object of the present invention to provide a polishing method and a polishing composition containing silica particles and a cellulose derivative that can achieve both haze reduction and wettability enhancement of a polished surface of a silicon wafer.

### [Solution to Problem]

According to the present specification, a polishing composition for a silicon wafer is provided. This polishing composition contains silica particles, a cellulose derivative, a basic compound, and water. Here, the silica particles have an average primary particle diameter of 30 nm or less and an average secondary particle diameter of 60 nm or less. The cellulose derivative has a weight average molecular weight (Mw) of more than 120 × 10⁴. By the polishing composition with such a constitution, both haze reduction and wettability enhancement of a polished surface of a silicon wafer can be achieved. More specifically, by using the silica particles with relatively small diameter and the cellulose derivative with relatively high molecular weight in combination, both the haze reduction and the wettability enhancement can be achieved.

In some preferred embodiments, the cellulose derivative has a weight average molecular weight of more than 150 × 10⁴. With the cellulose derivative as above, a polished surface more excellent in wettability can be achieved.

In some preferred embodiments, the content of the cellulose derivative is 0.1 to 20 parts by weight per 100 parts by weight of the silica particles. When the content of the cellulose derivative is in the predetermined range relative to the content of the silica particles, the effect by the art disclosed herein can be achieved suitably.

In some preferred embodiments, the polishing composition has a pH of 8.0 or more and 12.0 or less. With the polishing composition having the pH as described above, both the haze reduction and the wettability enhancement can be suitably achieved while exhibiting predetermined polishing removal efficiency.

In some preferred embodiments, the content of the silica particles is 0.01% by weight or more and 10% by weight or less. With the content of the silica particles set in the predetermined range, both the haze reduction and the polishing removal efficiency based on the silica particles can be achieved suitably.

In some preferred embodiments, the polishing composition further contains a surfactant. In the composition containing the cellulose derivative with the high molecular weight, using the silica particles with the relatively small diameter and the surfactant can effectively reduce the haze of the polished surface of the silicon wafer while achieving the wettability enhancement.

In some preferred embodiments, the polishing composition contains a nonionic surfactant as the surfactant. In the composition including the cellulose derivative with the high molecular weight, using the silica particles with the relatively small diameter and the nonionic surfactant in combination can achieve the haze reduction effect more suitably while achieving the wettability enhancement.

In some preferred embodiments, the surfactant has a molecular weight of less than 4000. In the composition containing the cellulose derivative with the high molecular weight, using the silica particles with the relatively small diameter and the surfactant with a molecular weight of less than 4000 in combination can effectively reduce the haze of the polished surface of the silicon wafer while achieving the wettability enhancement.

The polishing composition disclosed herein is preferably used for polishing the silicon wafer that has been subjected to lapping, for example. It is particularly preferable to be applied to a final polishing of silicon wafers.

In the present specification, a polishing method for a silicon wafer using any one of the polishing compositions disclosed herein is provided. The polishing method includes a stock polishing step and a final polishing step. In the final polishing step, a substrate to be polished is polished using a polishing composition. Here, the polishing composition contains silica particles, a cellulose derivative, a basic compound, and water, the silica particles have an average primary particle diameter of 30 nm or less and an average secondary particle diameter of 60 nm or less, and the cellulose derivative has a weight average molecular weight of more than 120 × 10⁴. By the polishing method, after the final polishing step, the high-quality surface of the silicon wafer with lower haze and higher wettability can be obtained.

### [Description of Embodiments]

Preferred embodiments of the present invention will be described below. Incidentally, matters other than those particularly mentioned in the present specification and necessary for the implementation of the present invention can be grasped as design matters of those skilled in the art based on the prior art in the relevant field. The present invention can be carried out based on the contents disclosed in this specification and technical common knowledge in the field.

### <Silica particle>

A polishing composition disclosed herein contains silica particles. The silica particles are used as an abrasive in the polishing composition. As the first feature, the silica particles contained in the polishing composition have an average primary particle diameter of 30 nm or less. With this feature, the haze of the polished surface of the silicon wafer is reduced. The average primary particle diameter is preferably less than 30 nm, and may be 29 nm or less. By the use of the silica particles with such small diameter, the surface of the silicon wafer can be processed uniformly. From the viewpoints of the polishing removal efficiency and the like, the average primary particle diameter of the silica particles is preferably 5 nm or more and more preferably 10 nm or more. From the viewpoint of obtaining a higher polishing effect, the average primary particle diameter is preferably 15 nm or more and more preferably 20 nm or more (for example, 25 nm or more).

In the present specification, the average primary particle diameter refers to the particle diameter (BET particle diameter) calculated by a formula of average primary particle diameter (nm) = 6000/(true density (g/cm³) × BET value (m²/g)) from the specific surface area (BET value) measured by the BET method. The specific surface area can be measured, for example, by using a surface area measuring apparatus "Flow Sorb II 2300" manufactured by Micromeritics Instrument Corporation.

As the second feature, the silica particles disclosed herein have an average secondary particle diameter of 60 nm or less. With this feature, the haze of the polished surface of the silicon wafer is reduced. The average secondary particle diameter is preferably 55 nm or less, and more preferably 50 nm or less (for example, less than 50 nm). By the use of the silica particles with such small diameter, the surface of the silicon wafer can be processed uniformly. From the viewpoint of improving the polishing removal efficiency, the average secondary particle diameter of the silica particles is preferably 30 nm or more, more preferably 35 nm or more, and still more preferably 40 nm or more (for example, more than 40 nm).

In the present specification, the average secondary particle diameter refers to the particle diameter measured by a dynamic light scattering method (volume average particle diameter). The average secondary particle diameter of the silica particles can be measured by the dynamic light scattering method using, for example, "NANOTRAC (registered trademark) UPA-UT151" manufactured by NIKKISO CO., LTD.

The silica particles may be any particles having the average primary particle diameter and the average secondary particle diameter as described above without particular limitation, and examples of the silica particles include colloidal silica, fumed silica, precipitated silica, and the like. The silica particles may be used singly or in combination of two or more kinds thereof. The use of colloidal silica is particularly preferable, since a polished surface excellent in surface quality can be easily obtained after polishing. As the colloidal silica, for example, colloidal silica produced by an ion exchange method using water glass (sodium silicate) as a raw material and alkoxide method colloidal silica (colloidal silica produced by a hydrolytic condensation reaction of an alkoxysilane) can be preferably used. The colloidal silica may be used singly or in combination of two or more kinds thereof.

The true specific gravity (true density) of silica forming the silica particles is preferably 1.5 or more, more preferably 1.6 or more, and still more preferably 1.7 or more. As the true specific gravity of the silica particle constituting material increases, the physical polishing ability tends to increase. The upper limit of the true specific gravity of the silica particle is not particularly limited and is typically 2.3 or less, for example, 2.2 or less, 2.0 or less, and 1.9 or less. The true specific gravity of the silica particle may be a value measured by a liquid displacement method using ethanol as a displacement liquid.

The shape (outer shape) of the silica particle may be globular or non-globular. Specific examples of the non-globular particles include particles of a peanut shape (that is, the shape of the peanut shell), a cocoon shape, a conpeito shape, a rugby ball shape, and the like. For example, the silica particles in which most of the particles have a peanut shape or a cocoon shape can preferably be used.

Although not particularly limited, the average value of the major axis/minor axis ratio (average aspect ratio) of the silica particles is in principle 1.0 or more, preferably 1.05 or more, and even more preferably 1.1 or more. By increasing the average aspect ratio, it is possible to achieve higher polishing removal efficiency. From the viewpoints of reducing scratching and the like, the average aspect ratio of the silica particles is preferably 3.0 or less, more preferably 2.0 or less, and even more preferably 1.5 or less.

The shape (outer shape) and the average aspect ratio of the silica particles can be grasped by, for example, observation with an electron microscope. A specific procedure for grasping the average aspect ratio includes, for example, drawing a minimum rectangle circumscribing each particle image for a predetermined number of silica particles (for example, 200 particles) for which the shape of an independent particle can be recognized by using a scanning electron microscope (SEM). Then, with respect to the rectangle drawn for each particle image, a value obtained by dividing the length of the longer side (value of major axis) by the length of the shorter side (value of minor axis) is calculated as the major axis/minor axis ratio (aspect ratio). By arithmetically averaging the aspect ratios of the predetermined number of particles, the average aspect ratio can be obtained.

The polishing composition disclosed herein may contain abrasives other than the silica particles (hereinafter also referred to as "non-silica abrasives") in the range that does not significantly impair the effects of the present invention. Examples of the non-silica abrasives include inorganic particles, organic particles, and organic-inorganic composite particles. Specific examples of the inorganic particles include oxide particles such as alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; carbonates such as calcium carbonate and barium carbonate; and the like. Specific examples of the organic particles include polymethyl methacrylate (PMMA) particles, poly(meth)acrylic acid particles (here, (meth)acrylic acid means to be inclusive of acrylic acid and methacrylic acid), polyacrylonitrile particles, and the like. Such abrasives may be used singly or in combination of two or more kinds thereof.

The art disclosed herein can be preferably implemented in an embodiment in which substantially only the silica particles are used as the abrasive. In such an embodiment, the effect of using the silica particles with the small diameter is suitably exhibited. From such a viewpoint, the proportion of the silica particles in the total amount of abrasives is suitably 90% by weight or more and more preferably 95% by weight or more, and may be, for example, 98% by weight or more (for example, 99 to 100% by weight).

### <Cellulose Derivative>

A cellulose derivative contained in the polishing composition disclosed herein is characterized by having a weight average molecular weight (Mw) of more than 120 × 10⁴. The Mw is measured by a method described in the example below (gel permeation chromatography (GPC)). Thus, in an embodiment of using the silica particles with the small diameter, the wettability of the polished surface of the silicon wafer can be enhanced while reducing the haze. The Mw of the cellulose derivative may be 125 × 10⁴ and is suitably more than 135 × 10⁴, and from the viewpoint of enhancing the wettability, the Mw of the cellulose derivative is preferably more than 150 × 10⁴, more preferably more than 180 × 10⁴, and still more preferably more than 200 × 10⁴. It is considered that the cellulose derivative with the larger Mw shows good adsorption to the surface of the silicon wafer and water, and contributes more to the wettability enhancement. The art disclosed herein, however, is not limited to this interpretation. The upper limit of the Mw of the cellulose derivative can be 300 × 10⁴ or less, is suitably 270 × 10⁴ or less, and may be 250 × 10⁴ or less from the viewpoints of the dispersibility and the like.

The relation between the weight average molecular weight (Mw) and the number average molecular weight (Mn) of the cellulose derivative is not particularly limited. For example, a molecular weight distribution (Mw/Mn) of the cellulose derivative is 4.0 or more and can be more than 5.0. The Mw/Mn may be 8.0 or more (for example, 9.0 or more). In the cellulose derivative whose Mw/Mn is the predetermined value or more, the act of the low-molecular-weight compound and the act of the highmolecular-weight compound can be well balanced. From the viewpoints of preventing the aggregation of the polishing composition and stabilizing the performance, the Mw/Mn can be 20 or less, is suitably 15 or less, and may be 12 or less. In the present specification, the Mn of the cellulose derivative is measured by a method (GPC) described in the example below in a manner similar to the Mw.

The cellulose derivative contained in the polishing composition disclosed herein is a polymer containing a β-glucose unit as a main repeating unit. Specific examples of the cellulose derivative include hydroxyethyl cellulose (HEC), hydroxypropyl cellulose, hydroxyethyl methyl cellulose, hydroxypropyl methyl cellulose, methylcellulose, ethylcellulose, ethyl hydroxyethyl cellulose, carboxymethyl cellulose, and the like, among which HEC is preferable. The cellulose derivative may be used singly or in combination of two or more kinds thereof.

Although not particularly limited, the content of the cellulose derivative in the polishing composition can be, for example, 0.01 parts by weight or more and may be 0.05 parts by weight or more per 100 parts by weight of the silica particles in the polishing composition. From the viewpoint of better exploitation of the effect due to use of the cellulose derivative, the content is preferably 0.1 parts by weight or more, more preferably 1 part by weight or more, and still more preferably 2 parts by weight or more, and for example, may be 3 parts by weight or more, 5 parts by weight or more, and 8 parts by weight or more. From the viewpoints of filtration ability of the polishing composition and the like, the content of the cellulose derivative per 100 parts by weight of the silica particles is usually 50 parts by weight or less, suitably 30 parts by weight or less, for example, and preferably 20 parts by weight or less, and for example, may be 15 parts by weight or less, 8 parts by weight or less, and 6 parts by weight or less.

### <Basic Compound>

The polishing composition disclosed herein contains a basic compound. The basic compound may be appropriately selected from various basic compounds that have a function of raising the pH of aqueous solutions in which the compounds are dissolved in water. For example, an organic or inorganic basic compound containing nitrogen, a basic compound containing phosphorus, an alkali metal hydroxide, an alkaline earth metal hydroxide, various carbonates, bicarbonates, and the like may be used. Examples of the basic compound containing nitrogen include a quaternary ammonium compound, ammonia, an amine (preferably, water-soluble amine), and the like. Examples of the basic compound containing phosphorus include a quaternary phosphonium compound. Such basic compounds may be used singly or in combination of two or more kinds thereof.

Specific examples of the alkali metal hydroxide include potassium hydroxide, sodium hydroxide, and the like. Specific examples of the carbonate and bicarbonate include ammonium hydrogen carbonate, ammonium carbonate, potassium hydrogen carbonate, potassium carbonate, sodium hydrogen carbonate, sodium carbonate, and the like. Specific examples of the amine include methylamine, dimethylamine, trimethylamine, ethylamine, diethylamine, triethylamine, ethylenediamine, monoethanolamine, N-(β-aminoethyl) ethanolamine, hexamethylenediamine, diethylenetriamine, triethylenetetramine, piperazine anhydride, piperazine hexahydrate, 1-(2-aminoethyl) piperazine, N-methylpiperazine, guanidine, azoles such as imidazole and triazole, and the like. Specific examples of the quaternary phosphonium compound include a quaternary phosphonium hydroxide such as tetramethylphosphonium hydroxide and tetraethylphosphonium hydroxide.

A quaternary ammonium salt (typically, strong base) such as a tetraalkylammonium salt or a hydroxyalkyltrialkylammonium salt can be used as the quaternary ammonium compound. An anion component in the quaternary ammonium salt may be, for example, OH⁻, F, Cl⁻, Br, I⁻, ClO₄⁻, or BH₄⁻. Examples of the quaternary ammonium compound include a quaternary ammonium salt with OH⁻ as an anion, that is, a quaternary ammonium hydroxide. Specific examples of the quaternary ammonium hydroxide include a tetraalkylammonium hydroxide such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; a hydroxyalkyltrialkylammonium hydroxide such as 2-hydroxyethyltrimethylammonium hydroxide (also referred to as choline); and the like.

The basic compound in the art disclosed herein is preferably at least one basic compound selected from an alkali metal hydroxide, a quaternary ammonium hydroxide, and ammonia. Among these, the quaternary ammonium hydroxide and ammonia are more preferable, and ammonia is particularly preferable. The art disclosed herein may be preferably implemented in an embodiment in which the basic compound contained in the polishing composition is substantially composed of ammonia. In this embodiment, the content of the basic compound other than ammonia (for example, quaternary ammonium hydroxide) may be 1/10 or less (for example, 1/30 or less) of the content of ammonia on a weight basis, and in the polishing composition, less than 0.003% by weight (moreover, less than 0.001% by weight). In such a constitution, the effect (both haze reduction and wettability enhancement) is suitably achieved by the art disclosed herein.

Although not particularly limited, the content of the basic compound in the polishing composition can be, for example, 0.01 parts by weight or more and may be 0.05 parts by weight or more per 100 parts by weight of the silica particles in the polishing composition. From the viewpoint of better exploitation of the effect due to use of the basic compound, the content is preferably 0.1 parts by weight or more, more preferably 0.5 parts by weight or more, and still more preferably 1.0 parts by weight or more. The content of the basic compound per 100 parts by weight of the silica particles can be 30 parts by weight or less, is suitably less than 10 parts by weight and preferably 5 parts by weight or less, and may be 3 parts by weight or less.

### <Optional Polymer>

The polishing composition disclosed herein may contain, as an optional component, a water-soluble polymer (hereinafter also referred to as "optional polymer") other than the cellulose derivative as long as it does not significantly impair the effects of the present invention. For example, a starch derivative, a polyvinyl alcohol-based polymer, an N-vinyl-based polymer, an N-(meth)acryloyl-based polymer, or the like can be used as the optional polymer. Examples of the starch derivative include pregelatinized starch, pullulan, carboxymethyl starch, cyclodextrin, and the like. The polyvinyl alcohol-based polymer refers to a polymer including a vinyl alcohol unit (hereinafter also referred to as "VA unit") as the repeating unit. The polyvinyl alcohol-based polymer may include only the VA unit as the repeating unit or may include a repeating unit other than the VA unit (hereinafter also referred to as "non-VA unit") in addition to the VA unit. The polyvinyl alcohol-based polymer may alternatively be non-modified polyvinyl alcohol (non-modified PVA) or modified polyvinyl alcohol (modified PVA). The N-vinyl-based polymer may be a homopolymer or copolymer of N-vinyl-based monomers. Specific examples of the N-vinyl-based polymer include a homopolymer of N-vinyl pyrrolidone (VP), a copolymer having a copolymerization ratio of VP of 70% by weight or more, and the like. The N-(meth)acryloyl-based polymer may be a homopolymer or copolymer of N-(meth)acryloyl-based monomers. Specific examples of the N-(meth)acryloyl-based polymer include a homopolymer of N-isopropylacrylamide (NIPAM), a copolymer having a copolymerization ratio of NIPAM of 70% by weight or more, a homopolymer of N-acryloylmorpholine (ACMO), a copolymer having a copolymerization ratio of ACMO of 70% by weight or more, and the like. The optional polymer is preferably nonionic. The content of the optional polymer per 100 parts by weight of the cellulose derivative is usually less than 100 parts by weight and suitably less than 50 parts by weight, and may be less than 30 parts by weight, less than 10 parts by weight, less than 5 parts by weight, and less than 1 part by weight. The art disclosed herein may be preferably implemented in an embodiment that does not substantially contain the optional polymer.

### <Surfactant>

The polishing composition in some preferred embodiments contains a surfactant. With the surfactant contained in the polishing composition, the haze of the polished surface of the object to be polished can be reduced more. The surfactant that can be used may be anionic, cationic, nonionic, or amphoteric. Usually, the anionic or nonionic surfactant may be preferably used. From the viewpoints of reducing foamability and enabling easy pH adjustment, the nonionic surfactant is more preferable. Examples of the nonionic surfactant include oxyalkylene polymers such as polyethylene glycol, polypropylene glycol, and polytetramethylene glycol; polyoxyalkylene derivatives (for example, polyoxyalkylene adducts) such as polyoxyethylene alkyl ethers, polyoxyethylene alkyl phenyl ethers, polyoxyethylene alkyl amines, polyoxyethylene fatty acid esters, polyoxyethylene glyceryl ether fatty acid esters, and polyoxyethylene sorbitan fatty acid esters; copolymers of a plurality of kinds of oxyalkylenes (for example, diblock copolymer, triblock copolymer, random copolymer, and alternating copolymer); and the like. As the surfactant to be contained, the surfactant with a polyoxyalkylene structure is preferable. The surfactant may be used singly or in combination of two or more kinds thereof.

Specific examples of the nonionic surfactant with the polyoxyalkylene structure include a block copolymer of ethylene oxide (EO) and propylene oxide (PO) (a diblock copolymer, a PEO (polyethylene oxide)-PPO (polypropylene oxide)-PEO triblock copolymer, a PPO-PEO-PPO triblock copolymer, and the like), a random copolymer of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene-2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrenated phenyl ether, polyoxyethylene lauryl amine, polyoxyethylene stearyl amine, polyoxyethylene oleyl amine, polyoxyethylene monolauric acid ester, polyoxyethylene monostearic acid ester, polyoxyethylene distearic acid ester, polyoxyethylene monooleic acid ester, polyoxyethylene dioleic acid ester, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, polyoxyethylene hydrogenated castor oil, and the like. Examples of the preferred surfactant include the block copolymer of EO and PO (particularly, PEO-PPO-PEO triblock copolymer), the random copolymer of EO and PO, and polyoxyethylene alkyl ether (for example, polyoxyethylene decyl ether).

When the polishing composition disclosed herein contains the surfactant, the surfactant has a molecular weight of less than 1 × 10⁴, typically. From the viewpoints of the filtration ability of the polishing composition, the cleanability of the polished object, and the like, the molecular weight is suitably less than 7000, and from the viewpoint of haze reduction, the molecular weight is preferably less than 4000 and more preferably less than 3500. From the viewpoints of the surface activity performance and the like, the molecular weight of the surfactant is usually suitably 200 or more, and from the viewpoints of the effect of the haze reduction and the like, the molecular weight of the surfactant is preferably 250 or more (for example, 300 or more). The range of more preferable molecular weight of the surfactant may vary according to the kind of the surfactant. For example, when polyoxyethylene alkyl ether is used as the surfactant, the molecular weight thereof is preferably 1500 or less and may be 1000 or less (for example, 500 or less). When the PEO-PPO-PEO triblock copolymer is used as the surfactant, for example, the molecular weight thereof may be, for example, 500 or more, 1000 or more, and further, 2000 or more (for example, 2500 or more).

Note that the molecular weight of the surfactant may be the weight average molecular weight (Mw) obtained by GPC or the molecular weight calculated from the chemical formula. In the case of obtaining the molecular weight of the surfactant by GPC, "HLC-8320GPC" manufactured by Tosoh Corporation may be used as a GPC measurement device. Measurement conditions may be as follows:
[GPC Measurement Conditions]
Sample concentration: 0.1% by weight
Column: TSKgel GMPW_{XL}
Detector: differential refractometer
Eluent: 100 mM of sodium nitrate aqueous solution
Flow rate: 1.0 mL/min
Measurement temperature: 40°C
Amount of sample injection: 200 µL
Standard sample: polyethylene oxide

When the polishing composition disclosed herein contains the surfactant, the content thereof is not particularly limited as long as the content is in the range that does not significantly impair the effects of the present invention. Usually, from the viewpoints of the cleanability and the like, the content of the surfactant per 100 parts by weight of the silica particles is suitably 20 parts by weight or less, preferably 15 parts by weight or less, and more preferably 10 parts by weight or less (for example, 8 parts by weight or less). The content per 100 parts by weight of the silica particles can be, for example, 5 parts by weight or less, 4 parts by weight or less, and 3 parts by weight or less. From the viewpoint of better exploitation of the effect due to use of the surfactant, the content of the surfactant per 100 parts by weight of the silica particles is suitably 0.001 parts by weight or more and preferably 0.005 parts by weight or more, and may be 0.01 parts by weight or more and 0.05 parts by weight or more. In some preferred embodiments, the content of the surfactant per 100 parts by weight of the silica particles may be 0.1 parts by weight or more from the viewpoint of the haze reduction. The polishing composition disclosed herein may be implemented even in an embodiment that does not substantially contain the surfactant.

### <Water>

The polishing composition disclosed herein typically contains water. Ion exchanged water (deionized water), pure water, ultrapure water, distilled water, and the like may be preferably used as the water. In order to minimize the inhibition of the action of other components contained in the polishing composition, the total content of transition metal ions in the water used is preferably, for example, 100 ppb or less. For example, the purity of water can be increased by operations such as removal of impurity ions with an ion exchange resin, removal of contaminants with a filter, and distillation.

### <Other Components>

The polishing composition disclosed herein may optionally contain a well-known additive that may be used in polishing compositions (typically, a polishing composition for a silicon wafer), such as a chelating agent, an organic acid, an organic acid salt, an inorganic acid, an inorganic acid salt, an antiseptic agent, and an antifungal agent, as long as it does not significantly impair the effects of the present invention. The polishing composition disclosed herein may be preferably implemented in an embodiment that does not substantially include the chelating agent.

The polishing composition disclosed herein is preferably substantially free of an oxidant. This is because the polishing removal rate can be lowered due to an oxide layer generated by oxidizing the surface of the object to be polished (silicon wafer) while the polishing composition including the oxidant is supplied to the object to be polished. Specific examples of the oxidant as used herein include hydrogen peroxide (H₂O₂), sodium persulfate, ammonium persulfate, sodium dichloroisocyanurate, and the like. The polishing composition being substantially free of the oxidant means that the oxidant is not included at least intentionally.

### <pH>

The pH of the polishing composition disclosed herein is usually suitably 8.0 or more, preferably 8.5 or more, more preferably 9.0 or more, and still more preferably 9.5 or more such as 10.0 or more. When the pH of the polishing composition increases, the polishing removal efficiency tends to be improved. Meanwhile, from the viewpoints of preventing dissolution of the silica particles and suppressing a decrease in the mechanical polishing effect by the silica particles, the pH of the polishing composition is suitably 12.0 or less, preferably 11.0 or less, more preferably 10.8 or less, and still more preferably 10.6 or less and is 10.3 or less, for example.

In the art disclosed herein, the pH of the composition can be grasped by performing threepoint calibration using a standard buffer solution (phthalate pH buffer solution, pH: 4.01 (25°C), neutral phosphate pH buffer solution, pH: 6.86 (25°C), carbonate pH buffer solution, pH: 10.01 (25°C)) by using a pH meter (for example, glass electrode type hydrogen ion concentration indicator (model type F-23) manufactured by Horiba Ltd.), placing a glass electrode in the composition to be measured, and measuring a pH value after the composition has been stabilized for 2 minutes or longer.

### <Polishing Slurry>

Typically, the polishing composition disclosed herein is supplied to the object to be polished in the form of a polishing slurry including the polishing composition, and is used for polishing the object to be polished. The polishing slurry may be prepared, for example, by diluting (typically diluting with water) any of the polishing compositions disclosed herein. Alternatively, the polishing composition may be used as it is as the polishing slurry. That is, the concept of the polishing composition in the art disclosed herein is inclusive of a polishing slurry (working slurry) that is supplied to an object to be polished and used for polishing the object to be polished, and a concentrate (that is, a stock solution of a polishing slurry) that is used as a polishing slurry after dilution. Another example of the polishing slurry including the polishing composition disclosed herein includes a polishing slurry prepared by adjusting the pH of the composition.

The content of the silica particles in the polishing composition is not particularly limited, and is typically 0.01% by weight or more, and preferably 0.05% by weight or more. The content thereof maybe 0.10% by weight or more, 0.15% by weight or more, 0.20% by weight or more, and 0.30% by weight or more, for example. Higher polishing removal efficiency may be achieved by increasing the content of the silica particles. The content is suitably 10% by weight or less, preferably 7% by weight or less, more preferably 5% by weight or less, and still more preferably 2% by weight or less, and may be 1% by weight or less and 0.5% by weight or less, for example. Accordingly, a surface having lower haze can be achieved. The aforementioned content of the silica particles can preferably be used in an embodiment in which the polishing composition is used in the form of the polishing slurry

The concentration of the cellulose derivative in the polishing composition is not particularly limited and may be, for example, 0.0001 % by weight or more, and from the viewpoint of better exploitation of the effect due to use of the cellulose derivative, the concentration is suitably 0.0005% by weight or more. From the viewpoints of enhancing the wettability of the polished surface and the like, the concentration of the cellulose derivative is preferably 0.001 % by weight or more and more preferably 0.002% by weight or more, and for example, may be 0.005% by weight or more and 0.008% by weight or more. From the viewpoints of the polishing removal efficiency and the like, the concentration of the cellulose derivative is usually preferably 0.2% by weight or less and more preferably 0.1% by weight or less, and may be 0.05% by weight or less (for example, 0.03% by weight or less). The aforementioned concentration of the cellulose derivative can preferably be used in an embodiment in which the polishing composition is used in the form of the polishing slurry

The concentration of the basic compound in the polishing composition disclosed herein is not particularly limited. From the viewpoints of the polishing removal efficiency and the like, the concentration is usually suitably 0.0005% by weight or more and preferably 0.001% by weight or more. From the viewpoints of the haze reduction and the like, the concentration is suitably less than 0.1% by weight, preferably less than 0.05% by weight, and more preferably less than 0.03% by weight (for example, less than 0.025% by weight). The aforementioned concentration of the basic compound can preferably be used in an embodiment in which the polishing composition is used in the form of the polishing slurry

When the polishing composition disclosed herein contains the surfactant, the concentration of the surfactant in the polishing composition is not particularly limited. The concentration of the surfactant can be 0.00001 % by weight or more, and from the viewpoint of the haze reduction, the concentration thereof is suitably 0.0001% by weight or more, preferably 0.0005% by weight or more, and more preferably 0.001% by weight or more. The concentration of the surfactant can be 0.5% by weight or less, and from the viewpoints of the polishing removal efficiency, the cleanability, and the like, the concentration thereof is suitably 0.25% by weight or less, preferably 0.1 by weight or less, and more preferably 0.05% by weight or less. The aforementioned concentration of the surfactant can preferably be used in an embodiment in which the polishing composition is used in the form of the polishing slurry.

### <Concentrate>

The polishing composition disclosed herein may be in a concentrated form before being supplied to the object to be polished (that is, the concentrated form may be the form of the concentrate of the polishing slurry and can be grasped as a stock solution of the polishing slurry). The polishing composition in such a concentrated form is suitable from the viewpoints of convenience in manufacturing, distribution, storage, cost reduction, and the like. The concentration factor is not particularly limited, and can be, for example, about 2 times to 100 times in terms of volume, and is usually suitably about 5 times to 50 times (for example, about 10 times to 40 times).

Such a concentrate can be used in an embodiment in which the concentrate is diluted at a desired timing to prepare the polishing slurry (working slurry) and this polishing slurry is supplied to the object to be polished. The dilution can be carried out, for example, by adding water to the concentrate and mixing.

### <Preparation of Polishing Composition>

The polishing composition used in the art disclosed herein may be in a one-agent type or a multi-agent type such as a two-agent type. For example, the polishing slurry can be prepared by mixing a part A containing at least the silica particles among the constituent components of the polishing composition and a part B containing at least a part of the remaining components, and mixing and diluting these at an appropriate timing as needed.

A method for preparing the polishing composition is not particularly limited. For example, the components constituting the polishing composition may be mixed using a well-known mixing device such as a blade stirrer, an ultrasonic disperser, or a homomixer. The mode of mixing these components is not particularly limited, and for example, all the components may be mixed at once or may be mixed in a properly set order.

### <Application>

The polishing composition according to the art disclosed herein can be used particularly preferably in polishing surfaces made of silicon (typically, polishing silicon wafers). A typical example of the silicon wafer referred to herein is a silicon single crystal wafer, for example, a silicon single crystal wafer obtained by slicing a silicon single crystal ingot.

The polishing composition disclosed herein can be preferably used in a polishing step of the object to be polished (for example, silicon wafer). Prior to the polishing step using the polishing composition disclosed herein, the object to be polished may be subjected to a general treatment that can be applied to the object to be polished in a step upstream of the polishing step, such as lapping or etching.

The polishing composition disclosed herein can be preferably used, for example, in polishing of the object to be polished (for example, silicon wafer), which has been prepared to have a surface state with a surface roughness of 0.01 nm to 100 nm in an upstream step. The surface roughness Ra of the object to be polished can be measured using, for example, a laser scanning type surface roughness meter "TMS-3000WRC" manufactured by Schmitt Measurement Systems Inc. The use of the polishing composition in the final polishing or the polishing immediately therebefore is effective, and the use thereof in the final polishing is particularly preferred. Here, the final polishing refers to the last polishing step in the process of manufacturing the object (that is, a step after which no further polishing is performed).

### <Polishing>

The polishing composition disclosed herein can be used for polishing the object to be polished in an embodiment including, for example, the following operations. Hereinafter, a favorable embodiment of a method for polishing the object to be polished (for example, silicon wafer) by using the polishing composition disclosed herein will be described.

That is to say, the polishing slurry including any of the polishing compositions disclosed herein is prepared. The preparation of the polishing slurry may include preparing the polishing slurry by adjusting the concentration of the polishing composition (for example, by dilution) or adjusting the pH, for example. Alternatively, the polishing composition may be used as it is as the polishing slurry.

Next, the polishing slurry is supplied to the object to be polished and polishing is performed by a conventional method. For example, in the case of the final polishing of a silicon wafer, typically, the silicon wafer that has been subjected to the lapping step is set in a general polishing machine and the polishing slurry is supplied to the surface to be polished of the silicon wafer through a polishing pad of the polishing machine. Typically, the polishing pad is pressed against the surface to be polished of the silicon wafer and the two are moved (for example, rotated) relative to each other while continuously supplying the polishing slurry. Through this polishing step, the polishing of the object to be polished is completed.

The polishing pad used in the polishing step is not particularly limited. For example, a polishing pad of a foamed polyurethane type, a nonwoven fabric type, a suede type, or the like can be used. Each polishing pad may or may not contain the abrasives. Usually, a polishing pad not containing the abrasives is preferably used.

The object to be polished, which has been polished using the polishing composition disclosed herein, is typically cleaned. Cleaning can be carried out using an appropriate cleaning solution. The cleaning solution to be used is not particularly limited, and for example, an SC-1 cleaning solution (mixed solution of ammonium hydroxide (NH₄OH), hydrogen peroxide (H₂O₂), and water (H₂O)), an SC-2 cleaning solution (mixed solution of HCl, H₂O₂, and H₂O), and the like generally used in the field of semiconductors and the like can be used. The temperature of the cleaning solution can be, for example, in the range from room temperature (typically about 15°C to 25°C) to about 90°C. From the viewpoint of improving the cleaning effect, the cleaning solution at about 50°C to 85°C can be preferably used.

### [Examples]

Several examples relating to the present invention will be described below; however, the present invention is not intended to be limited to these examples. In the following description, "%" is on a weight basis.

### <Preparation of Polishing Compositions>

### (Example 1)

The silica particles, the cellulose derivative, the basic compound, and deionized water (DIW) were mixed to prepare a polishing composition concentrate according to this example. As the silica particles, colloidal silica with an average primary particle diameter of 27 nm and an average secondary particle diameter of 46 nm was used. As the cellulose derivative, hydroxyethyl cellulose (HEC) with an Mw of 210 × 10⁴ was used. As the basic compound, ammonia was used. By diluting the obtained polishing composition concentrate with deionized water (DIW) 20 times in volume ratio, the polishing composition containing 0.17% of the silica particles, 0.018% of the cellulose derivative, and 0.01% of the basic compound was obtained.

### (Example 2)

A polishing composition according to the present example was prepared in a manner similar to Example 1 except that the content of the silica particles in the polishing composition was 0.34%.

### (Example 3)

A polishing composition according to the present example was prepared in a manner similar to Example 1 except that HEC with an Mw of 130 × 10⁴ was used as the cellulose derivative.

### (Example 4)

A polishing composition according to the present example was prepared in a manner similar to Example 2 except that the surfactant was added further. The concentration of the surfactant in the polishing composition was 0.024%. As the surfactant, a PEO-PPO-PEO triblock copolymer (EO : PO = 160 : 30 (molar ratio)) with a molecular weight of 3100 was used.

### (Example 5)

A polishing composition according to the present example was prepared in a manner similar to Example 4 except that polyoxyethylene decyl ether with a molecular weight of 378 (C10PEO5, the number of moles added of ethylene oxide is 5) was used as the surfactant and the concentration of the surfactant in the polishing composition was 0.012%.

### (Comparative Example 1)

A polishing composition according to the present example was prepared in a manner similar to Example 1 except that colloidal silica with an average primary particle diameter of 42 nm and an average secondary particle diameter of 66 nm was used as the silica particles and the content of the silica particles in the polishing composition was 0.46%.

### (Comparative Example 2)

A polishing composition according to the present example was prepared in a manner similar to Example 2 except that HEC with an Mw of 59 × 10⁴ was used as the cellulose derivative.

### <Measurement of Mw>

The Mw of the cellulose derivative used in each example was measured under the following GPC measurement conditions:

### [GPC Measurement Conditions]

Measurement device: HLC-8320GPC (manufactured by Tosoh Corporation)
Sample concentration: 0.1% by weight
Column: Asahipak GF-7M HQ, Asahipak GF-310 HQ
(7.5 mm I.D. × 300 mm × 2 pieces)
Eluent: 0.7% sodium chloride aqueous solution
Flow rate: 1.0 mL/min
Detector: differential refractometer
Column temperature: 40°C
Amount of sample injection: 100 µL
Standard sample: pullulan glucose

### <Polishing of Silicon Wafer>

A silicon wafer (conductive type: P type, crystal orientation: <100>, COP (Crystal Originated Particle, crystal defect)-free) with a diameter of 200 mm, which has been subjected to stock polishing under the following polishing conditions 1, was prepared as the object to be polished. The stock polishing was performed using a polishing slurry containing 1.0% of silica particles (colloidal silica with an average primary particle diameter of 42 nm) and 0.068% of potassium hydroxide in deionized water.

### [Polishing Conditions 1]

Polishing machine: single wafer polishing machine manufactured by Okamoto Machine Tool Works, Ltd., model "PNX-322"
Polishing pressure: 15 kPa
Platen rotational speed: 30 rpm
Head (carrier) rotational speed: 30 rpm
Polishing pad: product name "SUBA 800" manufactured by NittaHaas
Flow rate of stock polishing slurry: 0.55 L/min
Temperature of stock polishing slurry: 20°C
Temperature of platen cooling water: 20°C
Polishing time: 2 minutes

The polishing composition according to each example prepared as above was used as the polishing slurry, and the silicon wafer after the stock polishing was polished under the following polishing conditions 2.

### [Polishing Conditions 2]

Polishing machine: single wafer polishing machine manufactured by Okamoto Machine Tool Works, Ltd., model "PNX-322"
Polishing pressure: 15 kPa
Platen rotational speed: 30 rpm
Head (carrier) rotational speed: 30 rpm
Polishing pad: product name "SURFIN 000 FM" manufactured by Fujimi Incorporated
Flow rate of polishing slurry: 0.4 L/min
Temperature of polishing slurry: 20°C
Temperature of platen cooling water: 20°C
Polishing time: 4 minutes

The polished silicon wafer was removed from the polishing machine, and cleaned (SC-1 cleaning) using a cleaning solution of NH₄OH (29%) : H₂O₂ (31%) : deionized water (DIW) = 1 : 1 : 12 (volume ratio). Specifically, two cleaning tanks, that is, a first cleaning tank and a second cleaning tank, were prepared, and the cleaning solution was accommodated in each of the cleaning tanks and held at 60°C. The polished silicon wafer was immersed in the first cleaning tank for 5 minutes, immersed in ultrapure water in a rinse tank under ultrasonic vibrations, immersed in the second cleaning tank for 5 minutes, immersed in ultrapure water in the rinse tank under ultrasonic vibrations, and then dried with a spin dryer.

### <Measurement of Haze>

The haze (ppm) of the cleaned surface of the silicon wafer was measured using a wafer defect tester with the product name "Surfscan SP2^{XP}" manufactured by KLA-Tencor Corporation, the measurement being carried out in the DWO mode of the same device. The obtained results were converted into relative values (haze ratio) with the haze value in Comparative Example 1 being 100%, and shown in Table 1. When the haze ratio is less than 100%, it can be said that the haze improvement effect is confirmed significantly. As the value of the haze ratio is smaller, it means that the haze improvement effect is higher.

### <Water Repelling Distance after Polishing>

The silicon wafer was polished under the following conditions and the surface of the silicon wafer (surface to be polished) was cleaned for 10 seconds with flowing water at a flow rate of 7 L/min. The cleaned wafer was placed at rest with a diagonal line of the wafer in a vertical direction (vertical state), and a water repelling distance was measured after 3 minutes. Specifically, the length of a section, in the diagonal line on the surface of the wafer, that is not wetted with water from an edge of the wafer was measured and this value was recorded as the water repelling distance [mm].

The water repelling distance is an index of the wettability of the surface to be polished, and the water repelling distance tends to decrease as the surface to be polished has higher wettability. The maximum value of the water repelling distance in the present evaluation test is the length of the diagonal line of the wafer, that is, about 85 mm. The measurement results are shown in the respective columns in Table 1.

### (Polishing of Silicon Wafer)

A silicon wafer (conductive type: P type, crystal orientation: <100>, COP free) of 60 mm square was prepared as the object to be polished, and this silicon wafer was immersed in an HF aqueous solution (HF concentration: 2%) for 30 seconds to remove the oxide layer, and was polished under the following conditions using the polishing composition according to each example as the polishing slurry

### [Polishing Conditions]

Polishing machine: compact desktop lapping system manufactured by ENGIS JAPAN Corporation, model "EJ-380IN"
Polishing pressure: 21 kPa
Platen rotational speed: 30 rpm
Head (carrier) rotational speed: 30 rpm
Flow rate of polishing slurry: 0.6 L/min (one-way)
Temperature of polishing slurry: 20°C
Polishing time: 4 minutes

### [Table 1]

**Table 1**

| | Silica particles | | | Cellulose derivative | | Surfactant | | | Haze DWO [%] | Water repelling distance [mm] |
|---|---|---|---|---|---|---|---|---|---|---|
| | Average primary particle diameter [nm] | Average secondary particle diameter [nm] | Content [wt.%] | Species | Mw | S pecies | Molecular weight | Concentration [wt.%] | | |
| Example 1 | 27 | 46 | 0.17 | H E C | 2,100,000 | - | - | - | 93% | 7 |
| Example 2 | 27 | 46 | 0.34 | H E C | 2,100,000 | - | - | - | 93% | 7 |
| Example 3 | 27 | 46 | 0.17 | H E C | 1,300,000 | - | - | - | 93% | 8 |
| Example 4 | 27 | 46 | 0.34 | H E C | 2,100,000 | PEO-PPO-PEO | 3,100 | 0.024 | 84% | 8 |
| Example 5 | 27 | 46 | 0.34 | H E C | 2,100,000 | C10PEO5 | 378 | 0.012 | 82% | 8 |
| Comparative Example 1 | 42 | 66 | 0.46 | H E C | 2,100,000 | - | - | - | 100% | 7 |
| Comparative Example 2 | 27 | 46 | 0.34 | H E C | 590,000 | - | - | - | 93% | 12 |

As shown in Table 1, in Examples 1 to 5 in which the polishing composition contains the silica particles with an average primary particle diameter of 30 nm or less and an average secondary particle diameter of 60 nm or less and the cellulose derivative with an Mw of more than 120 × 10⁴, the haze of the polished surface of the silicon wafer was reduced compared to Comparative Example 1 in which the silica particles have an average primary particle diameter of more than 30 nm and an average secondary particle diameter of more than 60 nm. In addition, in Examples 1 to 5, the water repelling distance decreased compared to Comparative Example 2 in which the cellulose derivative has an Mw of 120 × 10⁴ or less. That is, it can be said that the wettability of the polished wafer improved.

The above results indicate that when the polishing composition contains the silica particles, the cellulose derivative, the basic compound, and water, the silica particles have an average primary particle diameter of 30 nm or less and an average secondary particle diameter of 60 nm or less, and the cellulose derivative has an Mw of more than 120 × 10⁴, both the haze reduction and the wettability enhancement can be achieved in the polishing of the silicon wafer.

Although specific examples of the present invention have been described in detail above, they are merely examples and do not limit the scope of the claims. The techniques described in the claims include those in which the specific examples exemplified above are variously modified and changed.

## Claims

1. A polishing composition for silicon wafer, the polishing composition comprising silica particles, a cellulose derivative, a basic compound, and water, wherein
the silica particles have an average primary particle diameter of 30 nm or less and an average secondary particle diameter of 60 nm or less, and
the cellulose derivative has a weight average molecular weight of more than 120 × 10⁴.

2. The polishing composition according to claim 1, wherein the cellulose derivative has a weight average molecular weight of more than 150 × 10⁴.

3. The polishing composition according to claim 1 or 2, wherein a content of the cellulose derivative is 0.1 to 20 parts by weight per 100 parts by weight of the silica particles.

4. The polishing composition according to any one of claims 1 to 3, wherein the polishing composition has a pH of 8.0 or more and 12.0 or less.

5. The polishing composition according to any one of claims 1 to 4, wherein a content of the silica particles is 0.01% by weight or more and 10% by weight or less.

6. The polishing composition according to any one of claims 1 to 5, further comprising a surfactant.

7. The polishing composition according to claim 6, containing, as the surfactant, a nonionic surfactant.

8. The polishing composition according to claim 6 or 7, wherein the surfactant has a molecular weight of less than 4000.

9. The polishing composition according to any one of claims 1 to 8, in use for final polishing of a silicon wafer.

10. A method for polishing a silicon wafer, the method comprising a stock polishing step and a final polishing step, wherein the final polishing step includes polishing a substrate to be polished using a polishing composition,
wherein the polishing composition comprises silica particles, a cellulose derivative, a basic compound, and water,
the silica particles have an average primary particle diameter of 30 nm or less and an average secondary particle diameter of 60 nm or less, and
the cellulose derivative has a weight average molecular weight of more than 120 × 10⁴.
